# EUROPEAN PATENT SPECIFICATION

(11) **EP 1 892 757 B1**
(45) Date of publication and mention of the grant of the patent: **07.06.2017**
(21) Application number: 07106361.4
(22) Date of filing: 17.04.2007
(51) Int. Cl.: H01L 21/768, H01L 21/3065

(54) **High aspect ratio via etch**
Ätzen von Vias mit hohem Aspektverhältnis
Gravure de trous d'interconnexion à rapport de forme élevé

(30) Priority: 25.08.2006 US 840222 P
(43) Date of publication of application: 27.02.2008
(73) Proprietor: IMEC, 3001 Leuven (BE)
(72) Inventor: Van Aelst, Joke, 3550, Heusden-Zolder (BE); Struyf, Herbert, 2550, Kontich (BE); Vanhaelemeersch, Serge, 3001, Leuven (BE)
(74) Representative: Pronovem

(56) References cited:
- EP-A1- 0 149 330
- WO-A-2006/086337
- JP-A- 2003 031 520
- JP-A- 2004 207 319
- US-A1- 2004 180 544
- US-A1- 2005 001 326
- US-A1- 2005 274 691

## Description

### FIELD OF INVENTION

The present invention is related to the field of etching high aspect ratio vias. More specifically to vias with aspect ratio up to 10:1.

The present invention is further characterized in eliminating undercut during etching high aspect ratios.

The present invention is further related to the creation of copper nails for 3 dimensional stacking of wafer to connect stacked interconnect structures.

The present invention is also related to the coupling of stacked semiconductor structures or components for Micro-Electro-Mechanical Systems (MEMS).

### BACKGROUND

Since traditional two dimensional (2D) planar architecture of interconnects in semiconductor devices inevitably imposes restrictions on miniaturization, new interconnection and packaging technologies need to be developed to keep on track with the continuously scaling of electronic systems. Three dimensional (3D) integration is an interesting solution since it allows for reduction of the system size, both in area and volume. Furthermore, it improves performance since 3D interconnects are shorter than in a 2D configuration, enabling a higher operation speed and smaller power consumption. A third advantage is the possibility of hetero-integration, the "seamless" mixing of different microelectronic technologies at wafer level. Different technology solutions are available for creating 3D interconnects. The highest interconnect density can be obtained with the 3D-stacked IC approach (3D-SIC). In this concept a deep via is etched through the Pre Metal Dielectric (PMD) into the Si after the front end of line (FEOL) processing. Only after metallizing the vias the back end of line (BEOL) processing is done. This puts minimal impact on CMOS wafer design because of the small exclusion area on the FEOL, the absence of impact on the BEOL wiring and the small number of necessary additional process steps.

Another promising application of using deep vias in stacked semiconductor structures is the coupling of stacked semiconductor structures or components for Micro-Electro-Mechanical Systems (MEMS) with each other by means of deep vias filled with conductive material.

The applications mentioned above require the etching of high-aspect ratio deep vias in a patterned thick semiconductor structure or a substrate and fill it with a conductive material. To ensure a reliable electrical connection between stacked semiconductor wafers or between elements of the devices in MEMS applications, a passivation layer, a barrier layer, and a seed conductive layer, such as a copper layer for electroplating needs to be deposited onto the sidewalls of the deep via. Said passivation and/or barrier layer must be smooth and uniform to allow the conductive material to uniformly fill the opening.

However, etching of said deep vias in the silicon substrate is not straightforward since standard etching procedures known in prior art for etching openings (vias) in a semiconductor substrate result in substantial undercut of the hardmask which is detrimental for the deposition of a conformal TaN barrier layer afterwards. The deep vias for connecting stacked 3D interconnects typically have an aspect ratio up to 10:1 which makes it impossible to use standard etching procedures.

One method available in the prior art to avoid the hardmask undercut is using a polymerizing etch process. During this process, a polymer layer is deposited on the sidewalls of the etched silicon substrate to block the lateral component of etching, resulting in a reduction of a hard mask undercut. However, this method employs ions with high energy, which may cause damage to a semiconductor structure due to an excessive ion bombardment. Further, the residuals of the polymer layer left on the sidewalls of the etched structure may cause a problem for a subsequent wet cleaning process. More specifically, the residuals of the polymer layer left on the sidewalls may impact the device's performance leading to a device reliability problem.

Another method that attempts to overcome the barrier layer non-uniformity caused by the oxide hardmask undercut uses the atomic layer deposition (ALD) process to deposit a uniform barrier layer. Since, during the ALD process, a material is deposited sequentially one atomic layer after another, this method is very time-consuming and expensive.

In US2005/0274691 a portion of the opening in the silicon substrate is etched generating a hard mask undercut. Then, the hard mask layer is trim-etched to remove the hard mask undercut. Next, the portion of the opening in the substrate is etched for a second time, generating a hard mask undercut for a second time. Trim-etching the hard mask followed by etching the portion of the opening in the substrate is continuously repeated until a predetermined depth of the opening in the substrate is achieved. This method is rather complicated and rather difficult to obtain smooth sidewalls and to have control on the CD of the via. JP 2003 031 520 discloses methods for etching deep silicon vias using masks, taking the problem of mask undercut into account by appropriate dimensioning of the initial mask patterns.

Thus, the prior art proposes several solutions for eliminating undercut but all of them do have serious drawbacks and shortcomings. The prior art does never provide a solution that eliminates the undercut in the silicon substrate without substantially altering the standard etch plasma and process used to etch a silicon substrate.

### AIM OF THE INVENTION

It is an aim of the invention to create (pattern) deep vias in a substrate for use in three dimensional stacked semiconductor devices and/or structures.

More specifically it is an aim to pattern deep vias with an aspect ratio up to 10 and even more into a (Si) substrate with smooth via sidewalls and sufficient slope and thereby avoiding hardmask undercut to enable metallization of the deep via.

### SUMMARY

The present invention relates to the patterning of deep vias in a substrate, said deep vias preferably having aspect ratios of more than 5, preferably of more than 10 (or in other words having a height to width ratio of more than 5:1, preferably of more than 10:1). The invention is defined in claim 1.

A method of the invention for etching a deep via in a substrate comprises the following steps. Providing a substrate with a first layer, preferably a permanent first layer, on top of said substrate.

Onto a (optionally permanent) first layer, at least one first lithographic imaging layer is deposited.

A first pattern with final aimed diameter of the deep via is formed into said first lithographic imaging layer (s) and said first pattern is transferred into said first layer (resulting in an opening into said first layer).

A uniform polymer type layer is then deposited on top of said patterned first layer such that the diameter of the first pattern becomes smaller (preferably 10% up to 20%) than the final aimed diameter.

Preferably said polymer type layer is a plasma generated (deposited in a plasma chamber) polymer layer such as a CₓH_{y}F_{z} (hydrofluorocarbon) comprising polymer.

The deep via is then etched into said substrate using the first pattern with said polymer layer on top as hard mask.

After removal of the first lithographic imaging layer(s) and polymer layer, a deep via without undercut is obtained.

The deep vias mentioned in the preferred embodiments herein are high aspect ratio vias having a width in the range of 1µm up to 10µm and a depth into the substrate in the range of 10µm up to 100µm.

More preferred, said deep vias are high aspect ratio vias having width of 5µm and a depth of 50µm.

The final aimed diameter of the deep via as described in the preferred methods above corresponds to the final aimed width of the vias, hence said final aimed (target) diameter is preferably in the range of 1µm up to 10µm, more preferred around 5µm.

Said high aspect ratio vias are preferably used for stacking semiconductor wafers, e.g. for three dimensional stacking of interconnect structures or stacking elements of devices in MEMS applications.

The substrate used can be a silicon substrate, or a silicon comprising substrate. Preferably, said substrate is a silicon substrate (Si-wafer).

A method of the invention can also apply to a germanium (Ge) wafer, or a Ge comprising wafer.

Said first layer situated on top of said substrate can be a sacrificial layer (which is to be removed in a subsequent step), and/or a protective layer.

Said first layer situated on top of said substrate is preferably a permanent layer (also referred to as a permanent first layer).

The permanent first layer mentioned in the preferred methods above situated on top of said substrate is preferably a Pre Metal Dielectric (PMD) layer, more preferred said PMD layer is SiO₂.

Alternatively said PMD layer can be made of a low-k material (i.e. material with a dielectric constant, k, lower than the dielectric constant of SiO₂) as conventionally used in semiconductor processing.

The lithographic imaging layer (s) mentioned in the preferred embodiments herein is/are preferably (a) resist layer(s) with optionally an anti-reflective coating. The removal (strip) of resist is preferably performed in a O₂/N₂ comprising plasma followed by a wet clean.

When a resist trim is performed in the preferred embodiments herein, this is preferably done in an O₂ comprising plasma with optional additions of Cl₂ and/or HBr.

The method used for etching the deep via in the Si substrate is performed in a passivation polymer type etch process using fluor comprising plasma, more particularly a C₄F₈/SF₆ comprising plasma, alternating a deposition followed by an etch step whereby said alternating deposition/etch steps are continuously repeated.

The deposition step is preferably performed using a C₄F₈ comprising plasma having more than 95% C₄F₈. The etch step is preferably performed using a SF₆ comprising plasma having more than 95% SF₆.

Furthermore the invention relates to the use of a method according to the preferred embodiments described herein for etching a via with a high aspect ratios (preferably around 10) in a substrate.

### BRIEF DESCRIPTION OF THE DRAWINGS

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.
Figure 1 (PRIOR ART) illustrates the problem of hard mask undercut and subsequent non-conformal deposition of a barrier layer using a standard etching procedure for etching the deep via into the substrate.
Figure 2 illustrates the method for etching a deep via into a substrate avoiding hard mask undercut according to the first embodiment of the invention.
Figure 5 shows a flow chart illustrating the main processing steps according to the first embodiment of the invention.
Figure 8 illustrates the results using the first preferred method of the invention to etch deep via with aspect ratio (AR) 5 using the double patterning approach.
Figure 9 illustrates the results using the first preferred method of the invention to etch deep via with aspect ratio (AR) 10 using the double patterning approach.

### DETAILED DESCRIPTION OF THE INTENTION

The following description illustrates methods to eliminate hardmask undercut during etching of deep vias into a substrate. It will be appreciated that there are numerous variations and modifications possible.

The drawings described are only schematic and are non-limiting. In the drawings, the size of some of the elements may be exaggerated and not drawn on scale for illustrative purposes. The dimensions and the relative dimensions do not correspond to actual reductions to practice of the invention.

In the context of the present invention, the term "etch undercut" or "hardmask undercut" refers to a beveled edge underneath the hardmask caused by the etchant attacking the sidewalls, due to the fact that the etch is not completely directional (vertical), and hence a small but not negligible lateral etch occurs.

In the context of the present invention, the term "aspect ratio" refers to the ratio of the height dimension to the width dimension of particular openings into which an electrical contact is to be placed. For example, a via opening which typically extends in a tubular form through a substrate (or multiple layers) has a height and a diameter, and the aspect ratio would be the height of the tubular divided by the diameter.

"Micro-electromechanical systems" or "MEMS" as used in the present invention refers to any integrated device containing electrical and mechanical systems such as, but not restricted to, cantilevers, airbridges, and membranes which undergo mechanical stress or strain during their operation.

The present invention provides a method for eliminating hardmask undercut during dry etching of an opening in a substrate.

More specifically a method is disclosed for etching vias with high aspect ratios in a substrate, also referred to as deep vias, thereby eliminating hardmask undercut into the substrate.

Said deep vias are typically used as 3-dimensional copper interconnects in stacked semiconductor devices, also referred to as copper nails.

Furthermore said deep vias can be used to stack semiconductor structures or components for Micro-Electro-Mechanical Systems (MEMS) with each other.

Said deep vias typically have a depth in the range of 10µm to 100µm.

More specifically said deep vias have an aspect ratio of 10:1, for example for use as copper nails in 3D stacked semiconductor devices. And more particularly, said deep vias have a preferred depth into the substrate of approximately 50µm and a diameter of approximately 5µm.

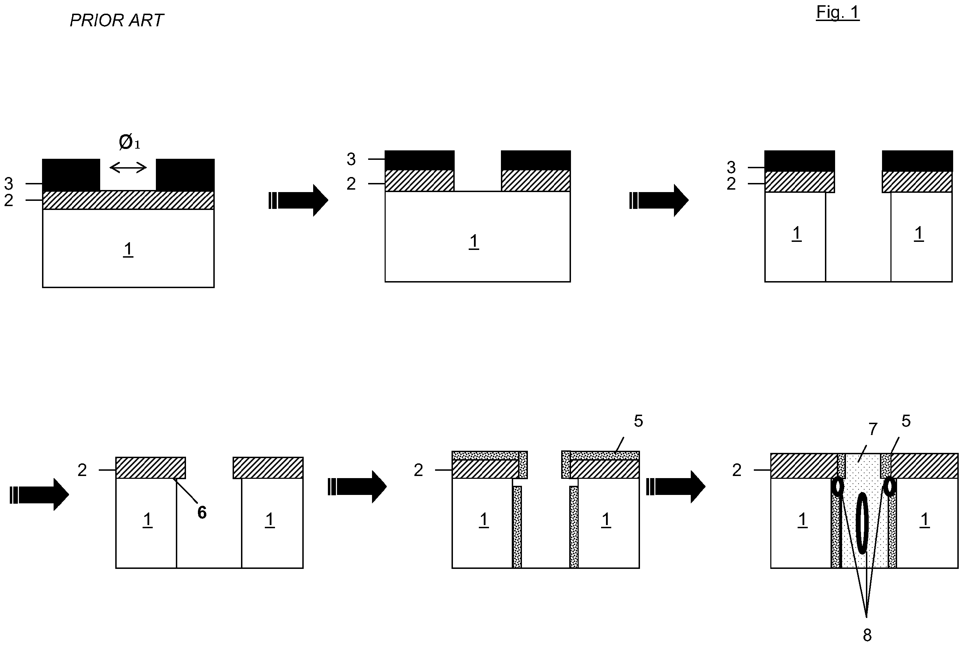

The present invention solves the problem of hardmask undercut 6 during etching of deep vias in a substrate 1 leading to a larger via diameter, a non-conformal deposition of the barrier layer 5 and voids 8 in the (copper) filling 7 as illustrated in Figure 1.

By avoiding said undercut 6 it is possible to deposit a conformal layer onto the sidewalls of said deep via after patterning.

For the creation of deep vias filled with conductive material (e.g. copper nails) said conformal layer is at least one barrier layer to avoid diffusion of conductive material into the substrate (dielectric material).

Further layers can be added to improve filling of the deep via with conductive material such as a seed layer needed to perform electrochemical plating.

According to preferred embodiments of the present invention a dry etch method is provided to etch deep vias into a substrate, preferably into a silicon substrate using a silicon dioxide layer as hard mask.

The present invention provides a method for etching, in a substrate (1), a deep via with a height to width ratio higher than 5:1, preferably of about 10:1 (or even higher), comprising the steps of:
- providing a substrate (1) with at least one protective layer (2), preferably a PMD layer (2), on top of said substrate (1),
- providing an opening through said protective layer(s) (2) by photolithographic and etching steps, said opening having a diameter (Ø_{opening}) equal to the final aimed diameter (Ø₁) of said deep via,
- depositing at least one lithographic imaging layer (3, 4) on top of said protective layer(s) (2), so as to form a pattern having a diameter (Øₚₐₜₜₑᵣₙ) smaller than the final aimed diameter (Ø₁) of said deep via,
- etching the deep via in said substrate (1) using said pattern as hard mask,
- removing said lithographic imaging layer(s) (3, 4), and
- removing, if any, the overhanging part of said protective layer(s) (2).

When said protective layer(s) (2) is/are meant to remain in the final structure, it is referred to herein as permanent layer(s) (2).

Said protective layer(s) (2) can also be one or more sacrificial layers (i.e. meant to be removed in a subsequent step).

Several embodiments can be derived from a method of the invention.

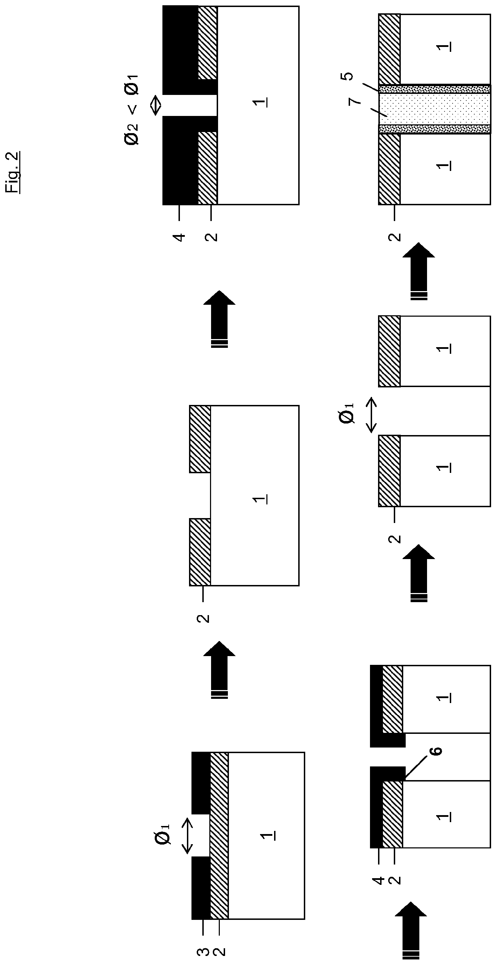

In a first embodiment (as represented by figure 2), said opening is made with a diameter equal to the final aimed diameter of the deep via (Ø_{opening} = Ø₁).

The lithographic and etching steps for creating said opening involve at least one first lithographic imaging layer (3).

After the lithographic and etching steps for creating said opening, at least one second lithographic imaging layer (4) is deposited for forming a pattern, coinciding with said opening, said pattern having a diameter (Øₚₐₜₜₑᵣₙ = Ø₂) smaller than the final aimed diameter of the deep via (Ø₂ < Ø₁).

Preferably, said pattern has a diameter about 10% to about 20% smaller than the final aimed diameter of the deep via (0,8.Ø₁ ≤ Øₚₐₜₜₑᵣₙ ≤ 0,9.Ø₁).

In the first embodiment, after the lithographic and etching steps for creating said opening, a uniform polymer layer is deposited such that said opening diameter is reduced. Preferably, the reduction is about 10% to 20%.

In the first lithographic step a mask having the final diameter of the deep via is used to create an opening in the layer(s) underneath the lithographic imaging layer(s).

After stripping the first lithographic imaging layer(s) (resist), a mask with a target dimension smaller than the final aimed diameter of the deep via is created.

Most preferred said second target dimension (pattern) is having a diameter of 10% to 20% smaller in dimension than the final aimed target dimension (final diameter of the deep via).

As an example for the patterning of deep vias with a final aimed diameter of 5 µm, a first lithographic step with target dimension of 5 µm is performed followed by reducing the target dimension to 4 µm. The substrate is etched, producing an undercut under the polymer layer which can be removed afterwards.

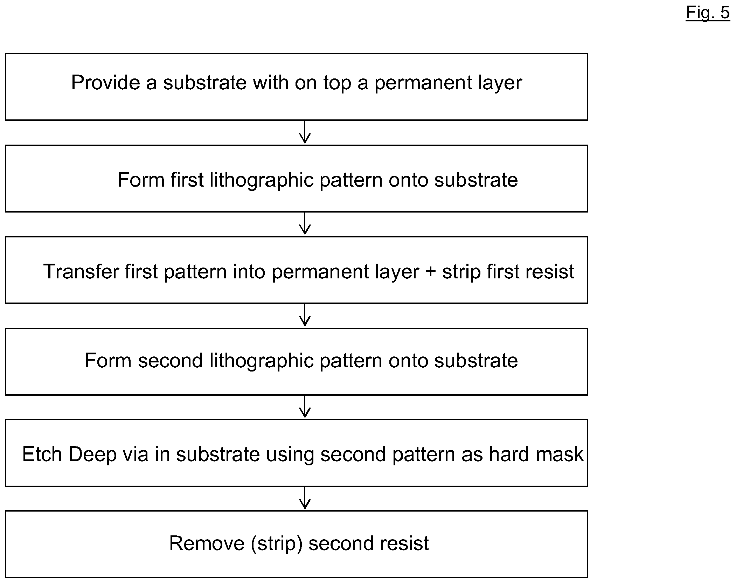

The preferred method for etching a deep via in a substrate according to the first embodiment is illustrated in Figure 2 and shown schematically in a flow chart in Figure 5.

The preferred method for etching a deep via in a substrate according to the first embodiment of the invention starts with the step of providing a substrate with a (permanent) first layer **2** on top of said substrate.

Said substrate **1** is preferably a semiconductor substrate, most preferred a silicon (Si) wafer or Si comprising wafer.

On top of said wafer is a first layer **2,** preferably a permanent first layer **2.**

For the patterning of deep vias for use in three dimensional stacking of wafers for connecting interconnect structures, said permanent first layer **2** is a Pre Metal Dielectric (PMD) layer. Most preferred said PMD layer is a SiO₂ layer.

At least one first lithographic imaging layer 3 is deposited on top of said permanent first layer **2.**

A first pattern with final aimed diameter of the deep via (equal to ø₁) is transferred into said first lithographic imaging layer(s) **2.** The first pattern (with width ø₁) is then transferred into the permanent first layer **2.**

The first lithographic imaging layer(s) **3** is/are then removed (resist strip) and at least one second lithographic imaging layer **4** is deposited on top of said patterned permanent first layer **2** creating a pattern having a diameter which is smaller than the first pattern (said second pattern having a width equal to ø₂), thereby reducing the diameter of said first pattern, preferably of 10% to 20%.

A deep via is then etched into the substrate **1** using the second pattern (said second pattern having a width equal to ø₂) as hard mask.

Preferably, the deep via etch is a passivation polymer type etch.

Said etch process is preferably using a fluor comprising plasma, preferably a C₄F₈/SF₆ comprising plasma, with alternating a deposition followed by an etch step whereby said alternating deposition/etch steps are continuously repeated.

Said deposition step is preferably performed using a C₄F₈/SF₆ comprising plasma having more than 90% C₄F₈, more preferred a plasma containing more than 95% C₄F₈ is used to perform the deposition step.

The etch step is performed using a C₄F₈/SF₆ comprising plasma having more than 90% SF₆, more preferred a plasma containing more than 95% SF₆ is used to perform the etch step.

Finally said second lithographic imaging layer(s) is/are removed (resist strip) with no undercut formed, resulting in a deep via with smooth sidewalls.

The removal of the second lithographic imaging layer (s) **4** is performed by a strip process. Said strip process can be performed using a O₂/N₂ plasma in a down stream asher followed by a conventional wet clean.

The method according to the first embodiment can be used for the creation of deep vias filled with conductive material **7** such as copper (also referred to as "copper nails") for 3D stacking of interconnect structures (ICs) of semiconductor devices (also referred to as 3D-SIC or 3 dimensional stacked ICs) into the substrate.

Said substrate is then preferably a silicon wafer comprising active devices (referred to as FEOL) with a Pre Metal Dielectric (PMD) layer on top of said substrate acting as the first permanent layer. Said PMD layer is preferably SiO₂. The first pattern, being equal to the final aimed diameter of the copper nail, is preferably in the range of 5 µm. The second pattern has preferably a diameter of 4 µm.

According to the first embodiment, the problem of hard mask undercut is thus solved and eliminated by means of using a second mask with a smaller opening such that after removal of said second mask no undercut is remaining.

According to the invention, the reduction of the diameter of the first pattern is achieved by the conformal deposition of a polymer type layer onto the first pattern.

This allows to obtain a pattern with reduced diameter (smaller than the final aimed diameter ø₁), said diameter is preferably having a width equal to ø₂, avoiding thereby the use of a second lithographic patterning step.

Accordingly, a method of the invention for etching a deep via in a substrate can comprise the steps of:
- providing a substrate with a permanent first layer on top of said substrate,
- depositing, onto said permanent first layer, at least one first lithographic imaging layer,
- forming a first pattern, with the final aimed diameter of the deep via, into said first lithographic imaging layer(s), and transferring said first pattern into said permanent first layer,
- depositing a uniform polymer type layer, on top of said patterned first layers, for reducing the diameter of said first pattern, preferably of 10% up to 20% (reduction of 10% to 20% compared to said final aimed diameter),
- etching the deep via into said substrate using the first pattern with said polymer layer on top as hard mask, and
- removing said first lithographic imaging layer(s) and said polymer layer,
whereby a deep via without undercut is obtained.

Preferably said polymer type layer is a plasma generated (deposited in a plasma chamber) polymer layer such as a CₓH_{y}F_{z} (hydrofluorocarbon) comprising polymer.

In a method according to the invention, said lithographic imaging layer(s) preferably comprise(s) at least one photoresist layer and optionally at least one anti-reflective coating layer (e.g. BARC).

In a method of the invention, said etching process for creation of the deep vias in said substrate is preferably a passivation polymer type etch process.

Said polymer type etch process comprises of at least two fast switching steps that are continuously repeated. Preferably, a fluor comprising plasma is used. More particularly, the first step is a C₄F₈ based process that acts as a deposition step which passivates the via bottom and sidewall and enhances the resist selectivity. The second step, using SF₆, is the actual etch step.

The method of the invention can further comprise, after the step of etching the deep via into the substrate, the steps of depositing a conformal barrier layer onto the sidewalls of said deep via and filling the vias with a conductive material.

Said barrier layer can be e.g. a PVD TaN barrier layer and the conductive material is preferably copper.

If needed a seedlayer can be deposited onto the barrier layer prior to the filling of the deep via with conductive material e.g. when using electrochemical deposition techniques. In other words, when using electrochemical deposition techniques for filling the vias with a conductive material, a method of the invention can further comprise the deposition of a seedlayer on the barrier layer.

### EXAMPLES

**Example 1:** Transferring the resist pattern into the Pre Metal Dielectric (PMD) layer used in the process sequence to create deep vias in a silicon substrate for use as copper nails in 3D stacking of interconnect structures.

The Pre Metal Dielectric is a 280nm SiO₂ layer.

The transfer of the resist pattern into said SiO₂ layer (also referred to as opening the SiO₂ layer) is done in a Lam Research Exelan chamber.

The etch recipe is :
**1.** Chamber Pressure: 20,4 Pa (153 mTorr)
**2.** Power 1000W₂₇/2000W₂
**3.** 335 sccm Ar
**4.** 18 sccm O₂
**5.** 50 sccm CF₄
**6.** time 28 seconds

**Example 2 :** Etching process to create deep vias in a silicon substrate for use as copper nails in 3D stacking of interconnect structures.

The method used for etching the deep vias in a silicon substrate as described in the preferred embodiments of the detailed description is illustrated in this example.

The example gives the etching characteristics used to create deep vias for use as copper nails in 3D stacking of interconnect structures.

These deep vias are created in a Si substrate, said Si substrate is a Si wafer comprising active devices (completed FEOL) with a Pre Metal Dielectric (PMD) layer on top of it. Said PMD layer is a permanent layer which needs to be left intact to protect the already created FEOL.

The Si etch is done in a Lam Research TCP9400DSiE chamber. The process used in the DSiE chamber comprises two fast switching steps that are continuously repeated (up to 800 times). The first step is C₄F₈ based and acts as a deposition step which passivates the via bottom and sidewall and enhances the resist selectivity. The second step, using SF₆, is the actual etch step. Since this is a fluorine rich plasma and because SFₓ polymers do not have sufficient protection properties, it typically gives rise to undercut under the hard mask.

The deposition parameters used during the deposition step are similar to the process described in US patent No. 5501893 using a plasma with more than 95% C₄F₈

The etch parameters during the etch step are similar to the process described in US patent No. 5501893 using a plasma with more than 95% SF₆

By changing the gas flow ratio between C₄F₈ and SF₆ it is possible to tune the process with respect to slope, etch stop (grass formation), resist selectivity and sidewall roughness. It was found that a ratio of 0.8-1.2 C₄F₈/SF₆ was the optimal condition in which polymer deposition at the bottom was such that no etch stop occurred while still enough resist selectivity and sidewall passivation by C₄F₈ was obtained as to reach a certain degree of slope.

**Example 3**: Removal of photolithographic imaging layers (resist strip) used in the process sequence to create deep vias in a silicon substrate for use as copper nails in 3D stacking of interconnect structures.

For etching deep vias (e.g. Cu nails) in a Si substrate, the patterned resist is used as hard mask during the reactive ion etching process to create the deep via. In this example the resist is a 3000nm deposited I-line resist (with vias with diameter of 5µm printed).

The resist trip is done with a O₂/N₂ plasma in a down stream asher, followed by a conventional SPM/APM wet clean.

**Example 4**: Trimming of photolithographic imaging layers (resist trim) used in the process sequence to create deep vias in a silicon substrate for use as copper nails in 3D stacking of interconnect structures.

The etch process used to trim the resist is done in a Lam Research Versys chamber.

The recipe used to trim resist is as follows:
- Chamber pressure: 2,7 Pa (20 mTorr)
- Power 1000 W (top)
- 190 sccm O₂

Pressure and power might be changed and Cl₂ and HBr might be added to the gas mixture to tune and optimize the recipe.

**Example 5**: Experimental results and proof of concept

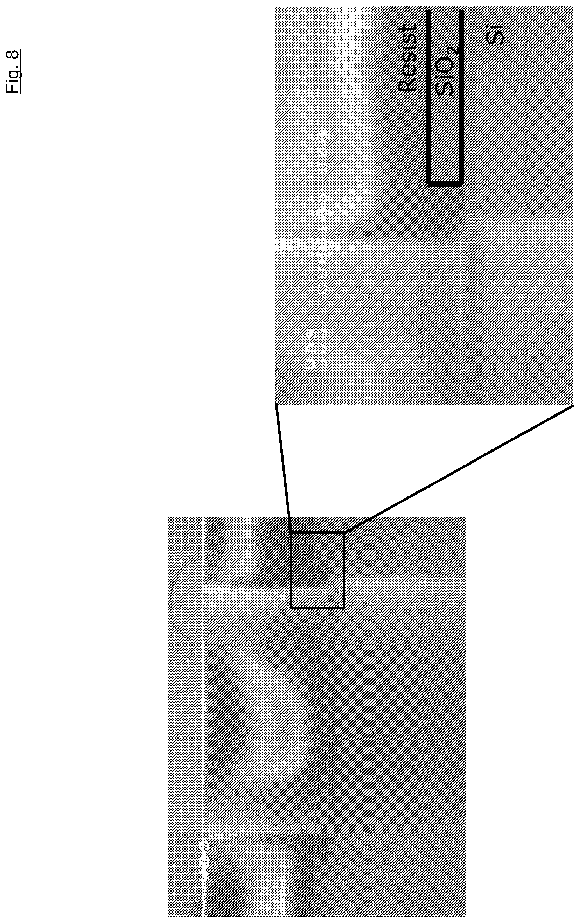

Figure 8 illustrates the results obtained when using the first preferred method of the invention to etch deep via with aspect ratio (AR) of 5 or in other words deep vias with a target depth of 50µm and a target width of 10µm using the double patterning approach.

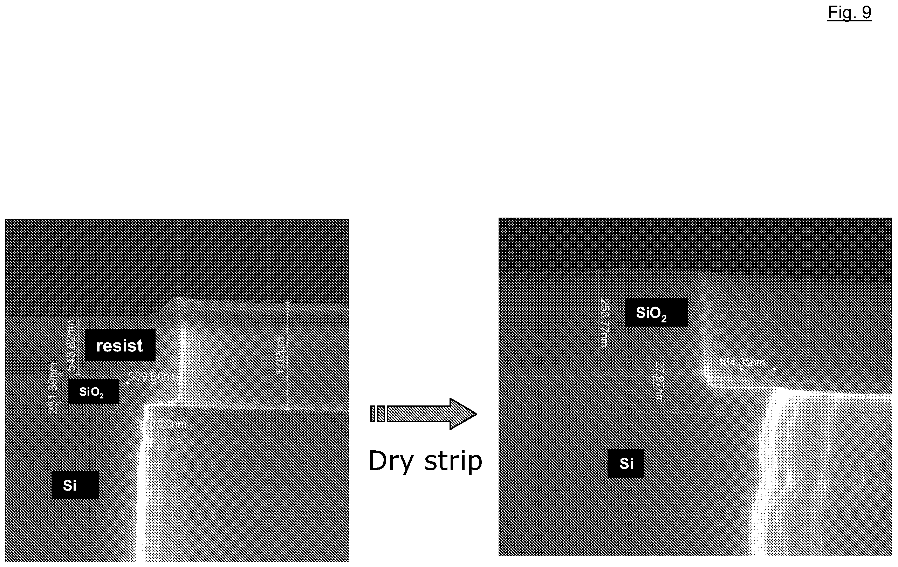

Figure 9 illustrates the results obtained when using the first preferred method of the invention to etch deep via with aspect ratio (AR) of 10 or in other words deep vias with a target depth of 50µm and a target width of 5µm using the double patterning approach.

In both cases the SiO₂ hardmask layer (PMD layer) has a thickness of around 250-300nm and the resist layer used to create the (smaller) second pattern has a thickness of around 2.5µm which is consumed partly during etching the deep via towards approximately 0.5 µm.

On the left side of Figure 8 and Figure 9 the results is shown before resist strip.

## Claims

1. A method for etching a deep via in a semiconductor substrate comprising the steps of:
- providing a substrate (1) with at least one first layer (2) on top of said substrate (1),
- depositing at least one first lithographic imaging layer (3) on top of said first layer(s) (2),
- forming a first pattern having the final aimed diameter of the deep via into said first lithographic imaging layer(s) (3),
- transferring said first pattern into said first layer(s) (2),
- removing said first lithographic imaging material(s) (3),
- depositing at least one uniform polymer layer on top and on the sidewalls of said patterned first layer(s) (2), thereby reducing the diameter of said first pattern,
- etching the deep via in said substrate (1) using the first pattern with said polymer layer on top as hard mask,
- removing said polymer layer.

2. A method according to any of claims 1, wherein said first layer(s) is/are (a) protective layer(s).

3. A method according to any of claims 1 to 2, wherein said first layer(s) is/are (a) sacrificial layer(s).

4. A method according to any of claims 1 to 3, wherein said deep vias have a height to width ratio higher than 5:1, preferably higher than 10:1.

5. A method according to any of claims 1 to 4, wherein said deep vias have a width in the range of 1µm up to 10µm and a depth into the substrate in the range of 10µm up top 100µm.

6. A method according to claim 5, wherein said deep vias have a width of 5µm and a depth of 50µm.

7. A method according to any of claims 1 to 6, wherein the uniform polymer layer induces a reduction of more than 10% and less than 20% in diameter.

8. A method according to any of claims 1 to 7, wherein said substrate (1) is a silicon substrate.

9. A method according to claim 1, wherein said first layer (2) on top of said substrate (1) is a permanent first layer (2).

10. A method according to claim 9, wherein said permanent first layer (2) is a Pre Metal Dielectric (PMD) layer.

11. A method according to claim 9 or 10, wherein said permanent first layer (2) on top of said substrate (1) is a SiO₂ layer.

12. A method according to any of claims 1 to 11, wherein said lithographic imaging layer(s) is/are resist layer(s) with, optionally, an anti-reflective coating.

13. A method according to any of claims 1 to 12, wherein said step of removing said lithographic imaging layers comprises using a O₂/N₂ comprising plasma followed by a wet clean.

14. A method according to any of claims 1 to 13, wherein said etching of the deep via in said substrate (1) is performed in a passivation polymer type etch process using a fluor comprising plasma.

15. A method according to claim 14, wherein said passivation polymer type etch process uses a C₄F₈/SF₆ comprising plasma and comprises alternating a deposition followed by an etch step, wherein said alternating deposition/etch steps are continuously repeated.

16. A method according to claim 15, wherein said deposition step is performed using a C₄F₈/SF₆ comprising plasma having more than 95% C₄F₈.

17. A method according to claim 15 or 16, wherein said etch step is performed using a C₄F₈/SF₆ comprising plasma having more than 95% SF₆.

18. A method according to any of claims 1 to 17 wherein said uniform polymer layer is a plasma generated polymer layer comprising hydrofluorocarbon.

19. A method according to any of the previous claims wherein said polymer layer is a conformal polymer layer.

## Patentansprüche

1. Verfahren zum Ätzen einer tiefen Durchkontaktierung in ein Halbleitersubstrat, das die Schritte umfasst:
- Bereitstellen eines Substrats (1) mit zumindest einer ersten Schicht (2) auf der Oberseite des Substrats (1),
- Abscheiden zumindest einer ersten lithographischen Bildgebungsschicht (3) auf der Oberseite des einen oder der mehreren ersten Schichten (2),
- Bilden eines ersten Musters mit dem finalen Zieldurchmesser der tiefen Durchkontaktierung in die eine oder mehreren ersten lithographischen Bildgebungsschichten (3),
- Übertragen des ersten Musters in die eine oder mehreren ersten Schichten (2),
- Entfernen des einen oder der mehreren ersten lithographischen Bildgebungsmaterialien (3),
- Abscheiden zumindest einer gleichmäßigen Polymerschicht auf der Oberseite und den Seitenwänden der einen oder mehreren gemusterten ersten Schichten (2), wodurch der Durchmesser des ersten Musters verringert wird,
- Ätzen der tiefen Durchkontaktierung in das Substrat (1) unter Verwendung des ersten Musters mit der Polymerschicht auf der Oberseite als Hartmaske,
- Entfernen der Polymerschicht.

2. Verfahren nach einem der Ansprüche 1, wobei die eine oder mehreren ersten Schichten eine oder mehrere Schutzschichten ist/sind.

3. Verfahren nach einem der Ansprüche 1 bis 2, wobei die eine oder mehreren ersten Schichten eine oder mehrere Opferschichten ist/sind.

4. Verfahren nach einem der Ansprüche 1 bis 3, wobei die tiefen Durchkontaktierungen ein Höhe-zu-Breite-Verhältnis von höher als 5:1, vorzugsweise höher als 10:1, aufweisen.

5. Verfahren nach einem der Ansprüche 1 bis 4, wobei die tiefen Durchkontaktierungen eine Breite im Bereich von 1 µm bis 10 µm und eine Tiefe in das Substrat im Bereich von 10 µm bis 100 µm aufweisen.

6. Verfahren nach Anspruch 5, wobei die tiefen Durchkontaktierungen eine Breite von 5 µm und eine Tiefe von 50 µm aufweisen.

7. Verfahren nach einem der Ansprüche 1 bis 6, wobei die gleichmäßige Polymerschicht eine Verringerung des Durchmessers von mehr als 10 % und weniger als 20 % induziert.

8. Verfahren nach einem der Ansprüche 1 bis 7, wobei das Substrat (1) ein Siliciumsubstrat ist.

9. Verfahren nach Anspruch 1, wobei die erste Schicht (2) auf der Oberseite des Substrats (1) eine permanente erste Schicht (2) ist.

10. Verfahren nach Anspruch 9, wobei die permanente erste Schicht (2) eine Pre-Metal-Dielectric-(PMD)-Schicht ist.

11. Verfahren nach Anspruch 9 oder 10, wobei die permanente erste Schicht (2) auf der Oberseite des Substrats (1) eine SiO₂-Schicht ist.

12. Verfahren nach einem der Ansprüche 1 bis 11, wobei die eine oder mehreren lithographischen Bildgebungsschichten eine oder mehrere Resistschichten mit, wahlweise, einer Antireflexionsbeschichtung, ist/sind.

13. Verfahren nach einem der Ansprüche 1 bis 12, wobei der Schritt des Entfernens der lithographischen Bildgebungsschichten das Verwenden eines O₂/N₂-umfassenden Plasmas, gefolgt von einer Nassreinigung, umfasst.

14. Verfahren nach einem der Ansprüche 1 bis 13, wobei das Ätzen der tiefen Durchkontaktierung in das Substrat (1) in einem Passivierungspolymertyp-Ätzprozess unter Verwendung eines fluorumfassenden Plasmas durchgeführt wird.

15. Verfahren nach Anspruch 14, wobei der Passivierungspolymertyp-Ätzprozess ein C₄F₈/SF₆-umfassendes Plasma verwendet und das Abwechseln einer Abscheidung, gefolgt von einem Ätzschritt, umfasst, wobei die abwechselnden Abscheidungs-/Ätzschritte kontinuierlich wiederholt werden.

16. Verfahren nach Anspruch 15, wobei der Abscheidungsschritt unter Verwendung eines C₄F₈/SF₆-umfassenden Plasmas mit mehr als 95 % C₄F₈ durchgeführt wird.

17. Verfahren nach Anspruch 15 oder 16, wobei der Abscheidungsschritt unter Verwendung eines C₄F₈/SF₆-umfassenden Plasmas mit mehr als 95 % SF₆ durchgeführt wird.

18. Verfahren nach einem der Ansprüche 1 bis 17 wobei die gleichmäßige Polymerschicht eine plasmaerzeugte Polymerschicht ist, die Fluorkohlenwasserstoff umfasst.

19. Verfahren nach einem der vorstehenden Ansprüche wobei die Polymerschicht eine konforme Polymerschicht ist.

## Revendications

1. Procédé de gravure d'un trou d'interconnexion profond dans un substrat semi-conducteur comprenant les étapes consistant à :
- fournir un substrat (1) ayant au moins une première couche (2) sur le dessus dudit substrat (1),
- déposer au moins une première couche d'imagerie lithographique (3) sur le dessus de ladite ou desdites premières couches (2),
- former un premier motif ayant le diamètre souhaité final du trou d'interconnexion profond dans ladite ou lesdites premières couches d'imagerie lithographique (3),
- transférer ledit premier motif dans ladite ou lesdites premières couches (2),
- enlever ledit ou lesdits premiers matériaux d'imagerie lithographique (3),
- déposer au moins une couche de polymère uniforme sur le dessus et sur les parois latérales de ladite ou desdites premières couches (2) à motif, réduisant ainsi le diamètre dudit premier motif,
- graver le trou d'interconnexion profond dans ledit substrat (1) en utilisant le premier motif avec ladite couche de polymère sur le dessus en tant que masque dur,
- enlever ladite couche de polymère.

2. Procédé selon la revendication 1, dans lequel ladite ou lesdites premières couches est/sont une/des couche(s) protectrice(s).

3. Procédé selon la revendication 1 ou 2, dans lequel ladite ou lesdites premières couches est/sont une/des couche(s) sacrificielle(s).

4. Procédé selon l'une quelconque des revendications 1 à 3, dans lequel lesdits trous d'interconnexion profonds ont un rapport de la hauteur à la largeur supérieur à 5:1, de préférence supérieur à 10:1.

5. Procédé selon l'une quelconque des revendications 1 à 4, dans lequel lesdits trous d'interconnexion profonds ont une largeur comprise dans la plage allant de 1 µm à 10 µm et une profondeur dans le substrat comprise dans la plage allant de 10 µm à 100 µm.

6. Procédé selon la revendication 5, dans lequel lesdits trous d'interconnexion profonds ont une largeur de 5 µm et une profondeur de 50 µm.

7. Procédé selon l'une quelconque des revendications 1 à 6, dans lequel la couche de polymère uniforme induit une réduction supérieure à 10 % et inférieure à 20 % du diamètre.

8. Procédé selon l'une quelconque des revendications 1 à 7, dans lequel ledit substrat (1) est un substrat de silicium.

9. Procédé selon la revendication 1, dans lequel ladite première couche (2) sur le dessus dudit substrat (1) est une première couche (2) permanente.

10. Procédé selon la revendication 9, dans lequel ladite première couche (2) permanente est une couche diélectrique pré-métallique (PMD).

11. Procédé selon la revendication 9 ou 10, dans lequel ladite première couche (2) permanente sur le dessus dudit substrat (1) est une couche de SiO₂.

12. Procédé selon l'une quelconque des revendications 1 à 11, dans lequel ladite ou lesdites couches d'imagerie lithographique est/sont une ou des couches de résine, facultativement avec un revêtement anti-réfléchissant.

13. Procédé selon l'une quelconque des revendications 1 à 12, dans lequel ladite étape d'élimination desdites couches d'imagerie lithographique comprend l'utilisation d'un plasma comprenant O₂/N₂ suivie par un nettoyage humide.

14. Procédé selon l'une quelconque des revendications 1 à 13, dans lequel ladite gravure du trou profond dans ledit substrat (1) est réalisée par un procédé de gravure de type passivation de polymère en utilisant un plasma comprenant du fluor.

15. Procédé selon la revendication 14, dans lequel ledit procédé de gravure de type passivation de polymère utilise un plasma comprenant C₄F₈/SF₆ et comprend l'alternance d'un dépôt suivi par une étape de gravure, lesdites étapes de dépôt/gravure en alternance étant répétées de manière continue.

16. Procédé selon la revendication 15, dans lequel ladite étape de dépôt est réalisée en utilisant un plasma comprenant C₄F₈/SF₆ ayant plus de 95 % de C₄F₈.

17. Procédé selon la revendication 15 ou 16, dans lequel ladite étape de gravure est réalisée en utilisant un plasma comprenant C₄F₈/SF₆ ayant plus de 95 % de SF₆.

18. Procédé selon l'une quelconque des revendications 1 à 17, dans lequel ladite couche de polymère uniforme est une couche de polymère générée par plasma comprenant un hydrofluorocarbure.

19. Procédé selon l'une quelconque des revendications précédentes, dans lequel ladite couche de polymère est une couche de polymère conforme.
